# EUROPEAN PATENT APPLICATION

(11) **EP 4 567 804 A1**
(43) Date of publication of application: **11.06.2025**
(21) Application number: 24216069.5
(22) Date of filing: 28.11.2024
(51) Int. Cl.: G11C 11/16, G11C 11/56, G11C 13/00

(54) **MEMORY DEVICE AND METHOD OF IMPLEMENTING MULTI-LEVEL MEMORY USING THE MEMORY DEVICE**

(30) Priority: 07.12.2023 KR 20230176800
(71) Applicant: Samsung Electronics Co., Ltd., Suwon-si, Gyeonggi-do 16677 (KR)
(72) Inventor: LEE, Changseung, 16678 Suwon-si (KR); YANG, Kiyeon, 16678 Suwon-si (KR); KANG, Youngjae, 16678 Suwon-si (KR); PARK, Jongbong, 16678 Suwon-si (KR); SUNG, Hajun, 16678 Suwon-si (KR); CHOI, Minwoo, 16678 Suwon-si (KR)
(74) Representative: Elkington and Fife LLP

(57) **Abstract**

Provided are a memory device and a method of implementing a multi-level memory using the memory device. The memory device includes first and second electrodes, a self-selecting memory layer, and a memory layer. The first and second electrodes are arranged apart from each other. The self-selecting memory layer is provided between the first and second electrodes, includes a chalcogenide-based material, has ovonic threshold switching characteristics, and has a threshold voltage variable according to a polarity and a magnitude of a voltage applied thereto. The memory layer is provided between the second electrode and the self-selecting memory layer and has resistance characteristics variable with a voltage applied thereto. Multi-level resistance states may be implemented by varying the polarity and magnitude of a voltage applied between the first and second electrodes.

## Description

### FIELD OF THE INVENTION

The disclosure relates to a memory device and a method of implementing a multi-level memory using the memory device.

### BACKGROUND OF THE INVENTION

Due to the development of lightweight, thin, and simple electronic products, the demand for highly integrated memory devices is increasing. In a memory device having a cross-point structure, word lines and bit lines vertically cross each other, and memory cells are arranged in regions in which the word lines and the bit lines cross each other. This structure guarantees a small memory cell size in a plan view. In general, memory cells having a cross-point structure include a 2-terminal selector and a memory device that are connected in series to each other to prevent the occurrence of a sneak current between adjacent memory cells. Recently, self-selecting memory (SSM) devices having both the function of a selector and the function of a memory device have been developed.

### SUMMARY OF THE INVENTION

Provided are a memory device and a method of implementing a multilevel memory using the memory device.

Additional aspects will be set forth in part in the description which follows and, in part, will be apparent from the description, or may be learned by practice of the presented embodiments of the disclosure.

According to an aspect of the disclosure, a memory device includes: a first electrode; a second electrode spaced apart from the first electrode; a self-selecting memory layer between the first and second electrodes, the self-selecting memory layer comprising a chalcogenide-based material, having ovonic threshold switching characteristics, and having a threshold voltage variable based on a polarity and a magnitude of a voltage applied to the self-selecting memory layer; and a memory layer between the second electrode and the self-selecting memory layer, the memory layer having variable resistance characteristics based on a voltage applied to the memory layer.

The memory layer may include at least one magnetic memory layer having a variable magnetic field based on a voltage applied thereto.

The self-selecting memory layer and the at least one magnetic memory layer may be electrically connected in series to each other.

The at least one magnetic memory layer is included in a plurality of magnetic memory layers connected in series to each other.

The memory device may be configured to have multi-level resistance states implemented by varying a polarity and a magnitude of a voltage applied between the first and second electrodes.

The self-selecting memory layer may include a chalcogen element including at least one of Se, Te, and S, and at least one of Ge, As, and Sb.

The at least one magnetic memory layer may include a pinned layer, a free layer apart from the pinned layer, and a tunnel barrier layer between the pinned layer and the free layer.

Each of the pinned layer and the free layer may include a ferromagnetic metal material having magnetism, and the tunnel barrier layer may include a crystalline metal oxide.

The memory device may further include a third electrode between the self-selecting memory layer and the memory layer.

According to another aspect of the disclosure, there is provided a method of implementing multiple levels using a memory device including a self-selecting memory layer between first and second electrodes, and at least one magnetic memory layer between the second electrode and the self-selecting memory layer, wherein the self-selecting memory layer comprises a chalcogenide-based material, having ovonic threshold switching characteristics, and having a threshold voltage variable based on a polarity and a magnitude of a voltage applied thereto, and the at least one magnetic memory layer has resistance characteristics variable with a magnetic field according to a voltage applied thereto, the method comprising: implementing multi-level resistance states by varying a polarity and a magnitude of a voltage applied between the first and second electrodes.

The self-selecting memory layer and the at least one magnetic memory layer may be electrically connected in series to each other.

The at least one magnetic memory layer may be included in a plurality of magnetic memory layers connected in series to each other.

Each of the multi-level resistance states may be determined by a sum of a first resistance of the self-selecting memory layer and a second resistance of the plurality of magnetic memory layers.

A number of levels of the second resistance may be greater than a number of the plurality of magnetic memory layers.

When a voltage having a first polarity is applied to the memory device, the first resistance may remain constant and the second resistance may vary as a magnitude of the voltage having the first polarity varies.

When a voltage having a second polarity is applied to the memory device, the first resistance and the second resistance may vary as a magnitude of the voltage having the second polarity varies.

According to another aspect of the disclosure, a memory device includes: a plurality of bit lines; a plurality of word lines crossing the plurality of bit lines; and a plurality of memory cells at positions at which the plurality of bit lines and the plurality of word lines cross each other, wherein each of the plurality of memory cells includes: a first electrode electrically connected to one of a corresponding bit line, of the plurality of bit lines, or a corresponding word line, of the plurality of word lines, a second electrode spaced apart from the first electrode and electrically connected to a remainer of the corresponding bit line or corresponding word line, a self-selecting memory layer between the first and second electrodes, the self-selecting memory layer comprising a chalcogenide-based material, has ovonic threshold switching characteristics, and has a threshold voltage variable based on a polarity and a magnitude of a voltage applied to the self-selecting memory layer; and at least one magnetic memory layer between the second electrode and the self-selecting memory layer, the at least one magnetic memory layer having on a variable magnetic field and variable resistance characteristics based on a voltage applied to the at least one magnetic memory layer.

The self-selecting memory layer and the at least one magnetic memory layer may be electrically connected in series to each other.

Each of the plurality of memory cells may be configured to such that multi-level resistance states are implemented by varying a polarity and a magnitude of a voltage applied between the first and second electrodes.

The plurality of bit lines and the plurality of word lines may be arranged in a multi-layer structure in which the plurality of bit lines and the plurality of word lines are alternately arranged in a vertical direction, and the plurality of memory cells are on upper and lower sides of each of the plurality of bit lines such that corresponding pairs of the plurality of memory cells are symmetrical with respect to a corresponding one of the plurality of bit lines.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a cross-sectional view schematically illustrating a memory device according to at least one embodiment;
FIG. 2 is a graph illustrating voltage-current characteristics of a self-selecting memory layer shown in FIG. 1;
FIG. 3A is a graph illustrating bias voltages applied to the self-selecting memory layer shown in FIG. 1 for a set operation and a read operation;
FIG. 3B is a graph illustrating bias voltages applied to the self-selecting memory layer shown in FIG. 1 for a reset operation and a read operation;
FIG. 4 is a graph illustrating voltage-current characteristics of the self-selecting memory layer shown in FIG. 1 according to the magnitude (strength) of a write voltage applied to the self-selecting memory layer;
FIG. 5 is a graph illustrating variations in the threshold voltage of the self-selecting memory layer shown in FIG. 1 according to the number of pulses of a write voltage applied to the self-selecting memory layer;
FIG. 6 is a graph illustrating variations in the threshold voltage of the self-selecting memory layer shown in FIG. 1 with respect to the width of pulses of a write voltage applied to the self-selecting memory layer in a reset operation;
FIG. 7 is a graph illustrating variations in the threshold voltage of the self-selecting memory layer shown in FIG. 1 with respect to the width of pulses of a write voltage applied to the self-selecting memory layer in a set operation;
FIG. 8 is a cross-sectional view schematically illustrating a memory device according to another embodiment;
FIG. 9 is a view illustrating an example in which three magnetic memory layers are connected in series to each other;
FIG. 10 is a graph illustrating results of simulating resistance states of the three magnetic memory layers connected in series to each other and shown in FIG. 9, according to voltages applied to the three magnetic memory layers;
FIG. 11 is a perspective view schematically illustrating a memory device according to another embodiment;
FIG. 12 is an enlarged view illustrating a portion of one memory cell of the memory device shown in FIG. 11;
FIG. 13 is a plan view illustrating an operation of selecting a specific memory cell in the memory device shown in FIG. 11;
FIG. 14 is a cross-sectional view schematically illustrating a memory device having a multi-layer structure according to another embodiment;
FIG. 15 is a conceptual view schematically illustrating a device architecture applicable to an electronic device according to at least one embodiment;
FIG. 16 is a block diagram illustrating a memory system according to at least one embodiment; and
FIG. 17 is a block diagram illustrating a neuromorphic apparatus and an external device connected thereto, according to at least one embodiment.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. Additionally, whenever a range of values is enumerated, the range includes all values within the range as if recorded explicitly clearly, and may further include the boundaries of the range. Accordingly, the range of "X" to "Y" includes all values between X and Y, including X and Y. Further, when the terms "about" or "substantially" are used in this specification in connection with a numerical value and/or geometric terms, it is intended that the associated numerical value includes a manufacturing tolerance (e.g., ±10%) around the stated numerical value. Further, regardless of whether numerical values and/or geometric terms are modified as "about" or "substantially," it will be understood that these values should be construed as including a manufacturing or operational tolerance (e.g., ±10%) around the stated numerical values and/or geometry.

Hereinafter, embodiments will be described with reference to the accompanying drawings. In the drawings, like reference numerals refer to like elements, and the sizes of elements may be exaggerated for clarity of illustration. The embodiments described herein are for illustrative purposes only, and various modifications may be made therein.

In the following description, when an element is referred to as being "above" or "on" another element, it may be directly on an upper, lower, left, or right side of the other element while making contact with the other element or may be above an upper, lower, left, or right side of the other element without making contact with the other element. For example, it will be understood that such spatially relative terms, such as "above", "top", etc., are intended to encompass different orientations of the device in use or operation in addition to the orientation depicted in the figures, and that the device may be otherwise oriented (rotated 90 degrees or at other orientations) and the spatially relative terms used herein interpreted accordingly. The terms of a singular form may include plural forms unless otherwise mentioned. It will be further understood that the terms "comprises" and/or "comprising" used herein specify the presence of stated features or elements, but do not preclude the presence or addition of one or more other features or elements.

An element referred to with the definite article or a demonstrative determiner may be construed as the element or the elements even though it has a singular form. Operations of a method may be performed in an appropriate order unless explicitly described in terms of order or described to the contrary, and are not limited to the stated order thereof.

In the disclosure, terms such as "unit" or "module" may be used to denote a unit that has at least one function or operation and is implemented with processing circuitry including hardware, software, or a combination of hardware and software. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components such as at least one of transistors, resistors, capacitors, etc., and/or electronic circuits including said components.

Furthermore, line connections or connection members between elements depicted in the drawings represent functional connections and/or physical or circuit connections by way of example, and in actual applications, they may be replaced or embodied with various additional functional connections, physical connections, or circuit connections.

Examples and/or exemplary terms are just used herein to describe technical ideas and should not be considered for purposes of limitation unless defined by the claims.

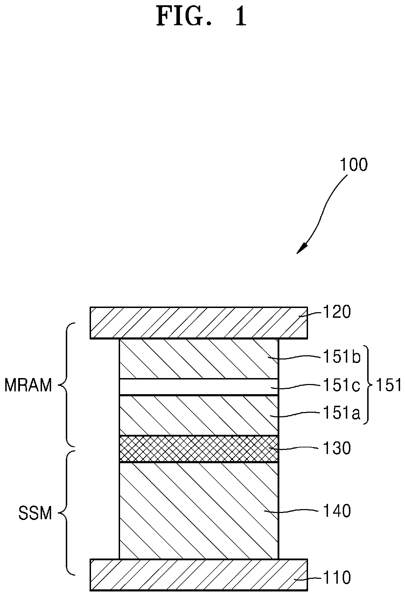

FIG. 1 is a cross-sectional view illustrating a memory device 100 according to at least one embodiment.

Referring to FIG. 1, the memory device 100 includes a first electrode 110 and a second electrode 120 arranged apart from each other, a self-selecting memory layer 140 disposed between the first and second electrodes 110 and 120, and a memory layer disposed between the second electrode 120 and the self-selecting memory layer 140 and having resistance characteristics varying with a voltage applied thereto. The memory layer includes a magnetic memory layer 151, and the resistance characteristics of the magnetic memory layer 151 may vary with a magnetic field according to a voltage applied thereto. For example, the magnetic memory layer 151 may be configured such that the application of voltage may adjust the strength and/or directionality of a magnetic field in the magnetic memory layer 151, thereby adjusting the resistance characteristics of the magnetic memory layers 151.

The first and second electrodes 110 and 120 are configured to have a function of applying a voltage to the self-selecting memory layer 140 and the magnetic memory layer 151. To this end, the first and second electrodes 110 and 120 may each include a metallically conductive material (e.g., a material without a band gap at the operational range), such as a metal, a conductive metal nitride, a conductive metal oxide, and/or a combination thereof. For example, the first and second electrodes 110 and 120 may each include at least of titanium nitride (TiN), titanium silicon nitride (TiSiN), titanium carbon nitride (TiCN), titanium carbon silicon nitride (TiCSiN), titanium aluminum nitride (TiAlN), tantalum (Ta), tantalum nitride (TaN), tantalum silicon nitride (TaSiN), tantalum aluminum nitride (TaAlN), tungsten silicide (WSi), titanium tungsten (TiW), molybdenum nitride (MoN), niobium nitride (NbN), titanium boron nitride (TiBN), zirconium silicon nitride (ZrSiN), tungsten silicon nitride (WSiN), tungsten boron nitride (WBN), zirconium aluminum nitride (ZrAlN), molybdenum aluminum nitride (MoAlN), titanium aluminum (TiAl), ttanium oxynitride (TiON), titanium aluminum oxynitride (TiAlON), tungsten oxynitride (WON), tantalum oxynitride (TaON), silicon carbon (SiC), silicon carbon nitride (SiCN), carbon nitride (CN), tantalum carbonitride (TaCN), tungsten (W), tungsten nitride (WN), carbon (C), and/or the like.

A third electrode 130 may be provided between the self-selecting memory layer 140 and the magnetic memory layer 151. The self-selecting memory layer 140 and the magnetic memory layer 151 may be electrically connected in series to each other. The third electrode 130 may include a conductive material such as a low-resistance metal and/or a metal nitride. For example, the third electrode 130 may include at least one of TiN or TaN. However, the composition of the third electrode 130 is not limited thereto.

The first electrode 110, the self-selecting memory layer 140, and the third electrode 130 may form a self-selecting memory (SSM). In addition, the third electrode 130, the magnetic memory layer 150, and the second electrode 120 may form a magneto-resistive random-access memory (MRAM). Thus, the memory device 100 of at least one embodiment may have a structure in which the SSM and the MRAM are connected in series to each other.

The self-selecting memory layer 140 may have ovonic threshold switching (OTS) characteristics in which the self-selecting memory layer 140 has a high-resistance state (e.g., when a voltage less than a threshold voltage of the self-selecting memory layer 140 is applied to the self-selecting memory layer 140) and a low-resistance state (e.g., when a voltage greater than the threshold voltage is applied to the self-selecting memory layer 140). In addition, the self-selecting memory layer 140 may have memory characteristics in which the threshold voltage of the self-selecting memory layer 140 shifts depending on the polarity and magnitude of a bias voltage applied to the self-selecting memory layer 140. Therefore, the self-selecting memory layer 140 may have both a memory function and a selector function.

In at least one embodiment, the self-selecting memory layer 140 may include a chalcogenide-based material. For example, the self-selecting memory layer 140 may include a chalcogen element including at least one of Se, Te, and/or S; and at least one of Ge, As, and/or Sb. The self-selecting memory layer 140 may further include at least one of In, Al, C, B, Sr, Ga, O, N, Si, Ca, and/or P. For example, the self-selecting memory layer 140 may include at least one of GeAsSe, GeAsSeIn, GeAsSeSIn, GeAsSeSb, GeAsSeTe, GeAsSeAl, GeAsSeAlIn, GeSbSe, GeAsSeGa, GeSe, GeSeIn, GeS, GeSIn, GeCTe, GeCTeN, and/or GeSbSeN.

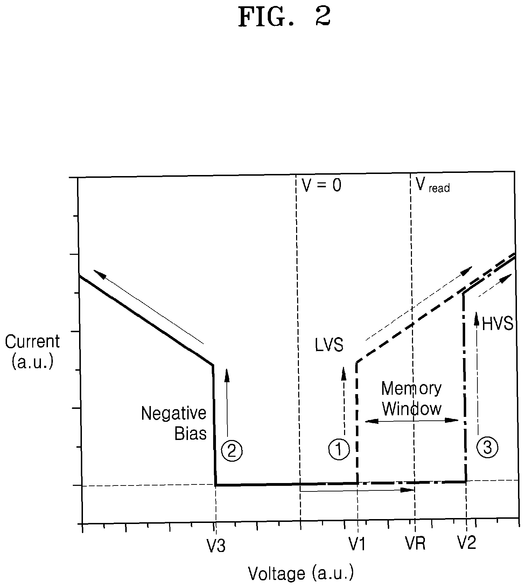

FIG. 2 is a graph illustrating voltage-current characteristics of the self-selecting memory layer 140 described with reference to FIG. 1.

Referring to FIG. 2, the self-selecting memory layer 140 may have one of a first state (low Vth state (LVS)) in which the threshold voltage of the self-selecting memory layer 140 is relatively low and a second state (high Vth state (HVS)) in which the threshold voltage of the self-selecting memory layer 140 is relatively high. For example, in the first state, the threshold voltage of the self-selecting memory layer 140 may be a first voltage V1, and in the second state, the threshold voltage of the self-selecting memory layer 140 may be a second voltage V2 that is greater than the first voltage V1.

When a voltage less than the first voltage V1 is applied to the self-selecting memory layer 140 in the first state, substantially no current flows between both ends of the self-selecting memory layer 140, and when a voltage greater than the first voltage V1 is applied to the self-selecting memory layer 140 in the first state, the self-selecting memory layer 140 turns on and current flows through the self-selecting memory layer 140. In addition, when a voltage less than the second voltage V2 is applied to the self-selecting memory layer 140 in the second state, substantially no current flows between both ends of the self-selecting memory layer 140, and when a voltage greater than the second voltage V2 is applied to the self-selecting memory layer 140 in the second state, the self-selecting memory layer 140 turns on and current flows through the self-selecting memory layer 140.

Therefore, a voltage ranging between the first voltage V1 and the second voltage V2 may be selected as a read voltage VR. When the read voltage VR is applied to the self-selecting memory layer 140 in the first state, current flows through the self-selecting memory layer 140, and a data value stored in the self-selecting memory layer 140 at this time may be defined as "1." When the read voltage VR is applied to the self-selecting memory layer 140 in the second state, substantially no current flows through the self-selecting memory layer 140, and a data value stored in the self-selecting memory layer 140 at this time may be defined as "0." In other words, a data value stored in the self-selecting memory layer 140 may be read by measuring a current flowing through the self-selecting memory layer 140 while applying the read voltage VR to the self-selecting memory layer 140.

In addition, when a negative bias voltage is applied to the self-selecting memory layer 140 in the first state, the threshold voltage of the self-selecting memory layer 140 may increase and the self-selecting memory layer 140 may transition to the second state. For example, when a negative third voltage V3 is applied to the self-selecting memory layer 140 in the first state, the self-selecting memory layer 140 may transition to the second state. This may be referred to as a 'reset' operation. In addition, when a positive bias voltage greater than the second voltage V2 is applied to the self-selecting memory layer 140 in the second state, the threshold voltage of the self-selecting memory layer 140 may decrease and the self-selecting memory layer 140 may transition to the first state. This may be referred to as a 'set' operation. The difference between the second voltage V2, which is a reset threshold voltage, and the first voltage V1, which is a set threshold voltage, corresponds to a memory window.

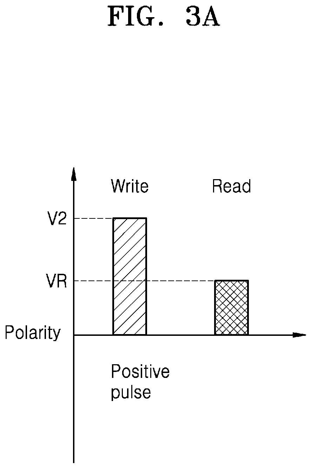

FIG. 3A is a graph illustrating bias voltages applied to the self-selecting memory layer 140 shown in FIG. 1 for a set operation and a read operation.

Referring to FIG. 3A, in the set operation, a positive (+) bias voltage greater than or equal to the second voltage V2 may be applied to the self-selecting memory layer 140. Then, the threshold voltage of the self-selecting memory layer 140 may be shifted to the first voltage V1. Then, in the read operation, a positive (+) read voltage VR ranging between the first voltage V1 and the second voltage V2 may be applied to the self-selecting memory layer 140. As such, when the positive (+) read voltage VR is applied to the self-selecting memory layer 140, the self-selecting memory layer 140 may turn on.

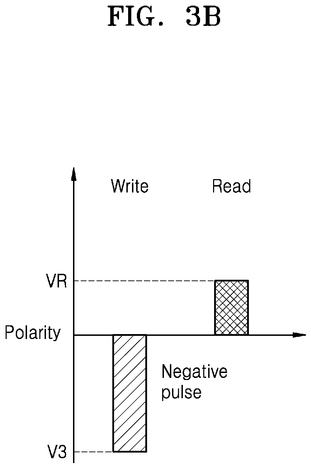

FIG. 3B is a graph illustrating bias voltages applied to the self-selecting memory layer 140 shown in FIG. 1 for a reset operation and a read operation.

Referring to FIG. 3B, in the reset operation, a negative (-) bias voltage (e.g., the third voltage V3) may be applied to the self-selecting memory layer 140. The absolute value of the third voltage V3 may be approximately equal to or slightly greater or less than the second voltage V2. Then, the threshold voltage of the self-selecting memory layer 140 may be shifted to the second voltage V2 that is greater than the first voltage V1. Then, in the read operation, a positive (+) read voltage VR ranging between the first voltage V1 and the second voltage V2 may be applied to the self-selecting memory layer 140. As such, when the read voltage VR is applied to the self-selecting memory layer 140, the self-selecting memory layer 140 may not turn on.

As described above, the self-selecting memory layer 140 may have OTS characteristics and may also have memory characteristics in which the threshold voltage of the self-selecting memory layer 140 varies. For example, the threshold voltage of the self-selecting memory layer 140 may be shifted according to the polarity of a bias voltage applied to the self-selecting memory layer 140.

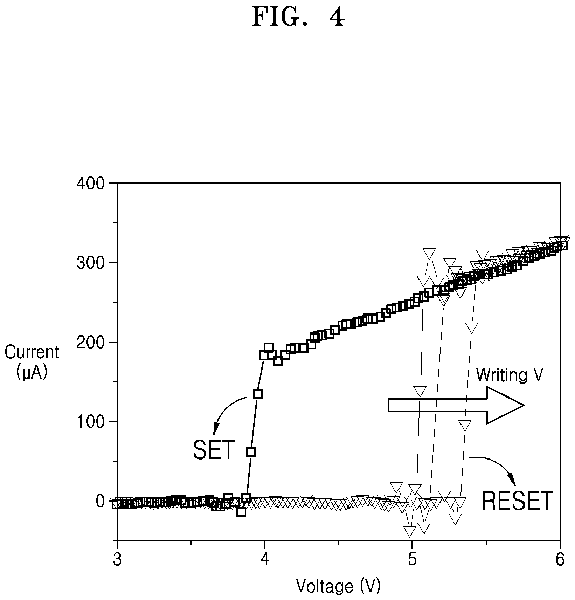

FIG. 4 is a graph illustrating voltage-current characteristics of the self-selecting memory layer 140 shown in FIG. 1 according to the magnitude (strength) of a write voltage applied to the self-selecting memory layer 140.

Referring to FIG. 4, when the write voltage applied to the self-selecting memory layer 140 has a positive (+) polarity, the set threshold voltage of the self-selecting memory layer 140 does not vary even through the magnitude (strength) of the write voltage increases. However, when the write voltage applied to the self-selecting memory layer 140 has a negative (-) polarity, the reset threshold voltage of the self-selecting memory layer 140 increases as the magnitude (strength) of the write voltage increases. Therefore, multi-level memory may be implemented using the self-selecting memory layer 140 by varying the magnitude of negative (-) polarity voltage.

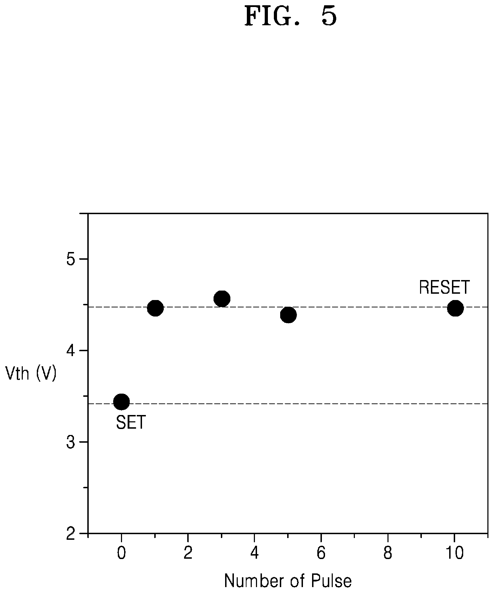

FIG. 5 illustrates variations in the threshold voltage Vth of the self-selecting memory layer 140 shown in FIG. 1 according to the number of pulses of a write voltage applied to the self-selecting memory layer 140.

Referring to FIG. 5, when the write voltage applied to the self-selecting memory layer 140 is a pulse voltage having a positive (+) polarity, the set threshold voltage of the self-selecting memory layer 140 does not vary even through the number of pulses increases. In addition, it is shown that even when the write voltage applied to the self-selecting memory layer 140 is a pulse voltage having a negative (-) polarity, the reset threshold voltage of the self-selecting memory layer 140 does not vary as the number of pulses increases.

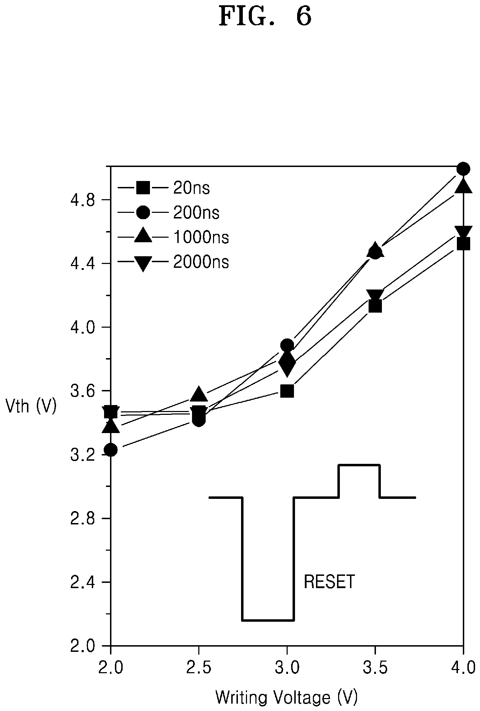

FIG. 6 illustrates variations in the threshold voltage Vth of the self-selecting memory layer 140 shown in FIG. 1 with respect to the width of pulses of a write voltage applied to the self-selecting memory layer 140 in a reset operation. FIG. 6 illustrates variations in the threshold voltage Vth of the self-selecting memory layer 140 according to the pulse height of the write voltage for pulse widths of 20 nanoseconds (ns), 200 ns, 1000 ns, and 2000 ns.

Referring to FIG. 6, it is shown that the threshold voltage Vth increases as the pulse height of the write voltage increases, but the threshold voltage Vth hardly varies even through the pulse width of the write voltage increases.

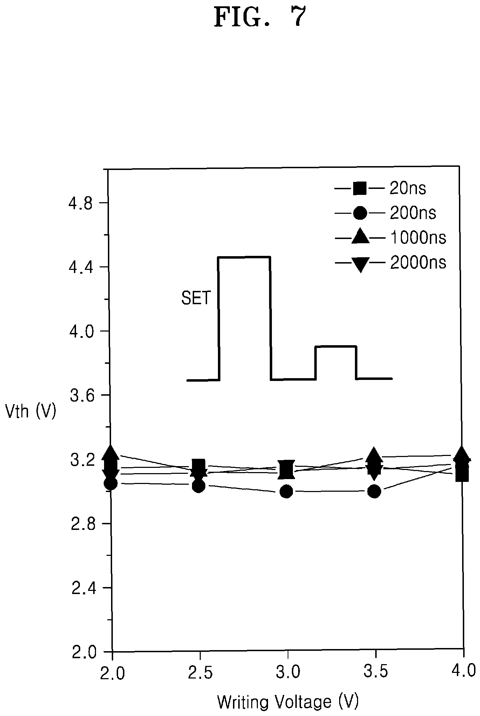

FIG. 7 illustrates variations in the threshold voltage Vth of the self-selecting memory layer 140 shown in FIG. 1 with respect to the width of pulses of a write voltage applied to the self-selecting memory layer 140 in a set operation. FIG. 7 illustrates variations in the threshold voltage Vth of the self-selecting memory layer 140 according to the pulse height of the write voltage for pulse widths of 20 ns, 200 ns, 1000 ns, and 2000 ns.

Referring to FIG. 7, it could be understood that the threshold voltage Vth does not vary even when the pulse height of the write voltage increases and hardly varies even when the pulse width of the write voltage increases.

As described above, it could be understood that when a write voltage for a set operation is a pulse voltage having a first polarity (for example, positive (+) polarity), the threshold voltage Vth of the self-selecting memory layer 140 does not vary even though the height, number, and width of pulses are varied. In addition, it could be understood that when a write voltage for a reset operation is a pulse voltage having a second polarity (for example, negative (-) polarity), the threshold voltage Vth of the self-selecting memory layer 140 varies in response to variations in the height of pulses but does not vary in response to variations in the number of pulses and variations in the width of pulses. Therefore, the resistance state of the self-selecting memory layer 140 may be varied by applying, as a write voltage, a pulse voltage having a second polarity (for example, negative (-) polarity) to the self-selecting memory layer 140 for a reset operation and varying the pulse height of the pulse voltage.

Referring back to FIG. 1, the magnetic memory layer 151 is provided between the second electrode 120 and the third electrode 130. The magnetic memory layer 151 may include a pinned layer 151a, a free layer 151b, and a tunnel barrier layer 151c. Here, the free layer 151b may face the pinned layer 151a, and the tunnel barrier layer 151c may be disposed between the pinned layer 151a and the free layer 151b.

The pinned layer 151a and the free layer 151b may each include a ferromagnetic metal material having magnetism. For example, the pinned layer 151a and the free layer 151b may each include of at least one of iron (Fe), cobalt (Co), nickel (Ni), manganese (Mn), ruthenium (Ru), an Fe-containing alloy, a Co-containing alloy, a Ni-containing alloy, a Mn-containing alloy, a Ru-containing alloy, and/or a Heusler alloy. The pinned layer 151a may be configured to have a fixed magnetization direction, and the free layer 151b may have a variable magnetization direction. The magnetic memory layer 151 may have low resistance when the magnetization directions of the pinned layer 151a and the free layer 151b are the same and high resistance when the magnetization directions of the pinned layer 151a and the free layer 151b are opposite. For example, the application of voltage may adjust the strength and/or directionality of a magnetic field in the magnetic memory layer 151, thereby adjusting the resistance characteristics of the magnetic memory layer 151 due, e.g., to the interaction between magnetic field of the pinned layer 151a and the free layer 151b. This phenomenon is called tunneling magnetoresistance (TMR), and owing to the TMR phenomenon, the magnetic memory layer 151 may have memory characteristics.

The pinned layer 151a and the free layer 151b may have high perpendicular magnetic anisotropy (PMA), for example, interface perpendicular magnetic anisotropy (IPMA). For example, the PMA energy of the pinned layer 151a and the free layer 151b may be greater than out-of-plane demagnetization energy. In this case, the magnetic moment of the pinned layer 151a and the free layer 151b may be stabilized in a direction perpendicular to a layer direction.

The free layer 151b may have a low saturation magnetization (Ms) to improve the operation speed of the magnetic memory layer 151. The free layer 151b may be further doped with a non-magnetic metal element to decrease the saturation magnetization of the free layer 151b. For example, the free layer 151b may be doped with at least one non-magnetic metal selected from calcium (Ca), scandium (Sc), yttrium (Y), magnesium (Mg), strontium (Sr), barium (Ba), zirconium (Zr), beryllium (Be), titanium (Ti), hafnium (Hf), vanadium (V), zinc (Zn), niobium (Nb), manganese (Mn), aluminum (Al), chromium (Cr), lithium (Li), cadmium (Cd), lead (Pb), indium (In)), gallium (Ga), and/or tantalum (Ta). The non-magnetic metal with which the free layer 151b is doped may have higher oxygen affinity than the oxygen affinity of the ferromagnetic metal material included in the free layer 151b. In addition, if necessary, the free layer 151b may have a multi-layer structure formed by two or more layers including a layer containing only a ferromagnetic metal material and a layer doped with a non-magnetic metal. Owing to the material and structure of the free layer 151b, diffusion of oxygen or metal elements may be reduced and/or prevented at an interface with the tunnel barrier layer 151c (described later).

The tunnel barrier layer 151c provides a magnetic tunneling junction between the pinned layer 151a and the free layer 151b. The tunnel barrier layer 151c may include a crystalline metal oxide. For example, the tunnel barrier layer 151c may include MgO, MgAl₂O₄, and/or MgTiOₓ.

When a pulse voltage having a first polarity (for example, positive (+) polarity) for a set operation is applied to the magnetic memory layer 151 as a write voltage, the magnetization directions of the pinned layer 151a and the free layer 151b are aligned opposite to each other, and thus, the magnetic memory layer 151 has a high resistance state (HRS). In this case, the resistance state of the magnetic memory layer 151 does not change even when the height of pulses varies. In addition, when a pulse voltage having a second polarity (for example, negative (-) polarity) is applied as a write voltage to the magnetic memory layer 151, the magnetization directions of the pinned layer 151a and the free layer 151b are aligned to be the same, and thus, the magnetic memory layer 151 has a low resistance state (LRS). In this case, the resistance state of the magnetic memory layer 151 does not change even when the height of pulses varies.

According to at least one embodiment, the memory device 100 may have a structure in which the SSM and the MRAM are connected in series to each other. In some embodiments, the SSM may include the self-selecting memory layer 140, and the MRAM may include the magnetic memory layer 151. The resistance of the memory device 100 may be determined by the sum of the resistance of the self-selecting memory layer 140 and the resistance of the magnetic memory layer 151.

Table 1 shows resistance states according to the height of pulses of a write voltage applied between the first and second electrodes 110 and 120 of the memory device 100 shown in FIG. 1 for the cases in which a pulse voltage having a positive (+) polarity for a set operation is applied as a write voltage and a pulse voltage having a negative (-) polarity for a reset operation is applied as a write voltage. Here, the write voltage may be the sum of the threshold voltage of the SSM and the threshold voltage of the MRAM.

In Table 1, "R(SSM)" refers to the resistance of the self-selecting memory layer 140, and "R(MRAM)" refers to the resistance of the magnetic memory layer 151. This applies to the following description.

**[Table 1]**

| **Resistance** | **SET +V** | **RESET -V1** | **RESET -V2** | **RESET -V3** |
|---|---|---|---|---|
| R(SSM) | S(LRS) | S(HRS1) | S(HRS2) | S(HRS3) |
| R(MRAM) | M(HRS) ) | M(LRS) | M(LRS) | M(LRS) |

Referring to Table 1, when a pulse voltage +V having a positive (+) polarity for a set operation is applied to the memory device 100, the resistance R(SSM) of the self-selecting memory layer 140 may have a low resistance value S(LRS) that remains constant even when the height of pulses varies. In addition, the resistance R(MRAM) of the magnetic memory layer 151 may have a high resistance value M(HRS) that remains constant even when the height of pulses varies. Therefore, when the pulse voltage +V for the set operation is applied to the memory device 100, the resistance of the memory device 100 may be S(LRS)+M(HRS).

When a pulse voltage having a negative (-) polarity for a reset operation is applied to the memory device 100, the resistance R(SSM) of the self-selecting memory layer 140 may vary according to the height of pulses, but the resistance R(MRAM) of the magnetic memory layer 151 may be constant. For example, when pulse voltages having a negative (-) polarity, that is, -V1, - V2, and -V3 (V1 <V2<V3), are applied to the memory device 100, the resistance R(SSM) of the self-selecting memory layer 140 may be S(HRS1), S(HRS2), and S(HRS3), respectively (S(HRS1)<S(HRS2)<S(HRS3)). In addition, the resistance R(MRAM) of the magnetic memory layer 151 may have a low resistance value M(LRS) that remains constant even when the height of pulses varies. Therefore, when the pulse voltages -V1, -V2, and -V3 for a reset operation are applied to the memory device 100, the resistance of the memory device 100 may be S(HRS1)+M(LRS), S(HRS2)+M(LRS), and S(HRS3)+M(LRS), respectively.

As described above, when the memory device 100 includes the self-selecting memory layer 140 and the magnetic memory layer 151 that are connected in series to each other, up to four multi-resistance states (levels) may be implemented.

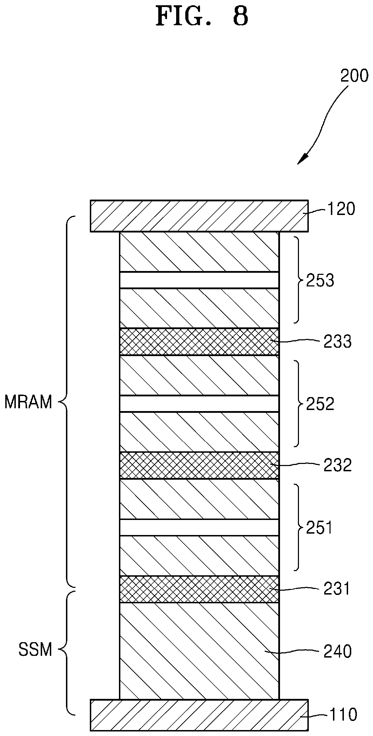

FIG. 8 schematically illustrates a cross-section of a memory device 200 according to another embodiment. Hereinafter, the differences from the previous embodiments are mainly described.

Referring to FIG. 8, the memory device 200 includes first and second electrodes 110 and 120 arranged apart from each other, a self-selecting memory layer 240 disposed between the first and second electrodes 110 and 120, and a memory layer disposed between the second electrode 120 and the self-selecting memory layer 240 and having resistance characteristics varying according to a voltage applied thereto. Here, the memory layer includes a plurality of magnetic memory layers 251, 252, and 253, and the resistance characteristics of the magnetic memory layers 251, 252, and 253 are variable by a magnetic field according to a voltage applied thereto. For example, as discussed above, with relation to the magnetic memory layer 151, the application of voltage may adjust the strength and/or directionality of the magnetic field, thereby adjusting the resistance characteristics of the magnetic memory layers 251, 252, and 253. A third electrode 231 may be provided between the self-selecting memory layer 240 and the magnetic memory layers 251, 252, and 253; and a fourth electrode 232 may be provided between the first and second magnetic memory layers 251 and 252, and a fifth electrode 233 may be provided between the second and third magnetic memory layers 252 and 253.

The first electrode 110, the self-selecting memory layer 240, and the third electrode 231 may form an SSM. The third electrode 231, the magnetic memory layers 251, 252, and 253, and the second electrode 120 may form an MRAM. That is, the memory device 200 of the embodiment may have a structure in which the SSM and the MRAM are connected in series to each other. The first, second, and third electrodes 110, 120, and 231, and the self-selecting memory layer 240 are substantially the same as those described above, and thus, descriptions thereof are omitted here.

The self-selecting memory layer 240 and the magnetic memory layers 251, 252, and 253 may be electrically connected in series to each other. The magnetic memory layers 251, 252, and 253 may be respectively referred to as first, second, and third magnetic memory layers 251, 252, and 253 that are electrically connected in series to each other. Each of the first, second, and third magnetic memory layers 251, 252, and 253 is substantially the same as (and/or substantially similar to) the magnetic memory layer 151 described with reference to FIG. 1, and thus, descriptions thereof are omitted here. Additionally, the composition of the fourth electrode 232 and the fifth electrode 233 may be the same as (and/or substantially similar to) the third electrode 231.

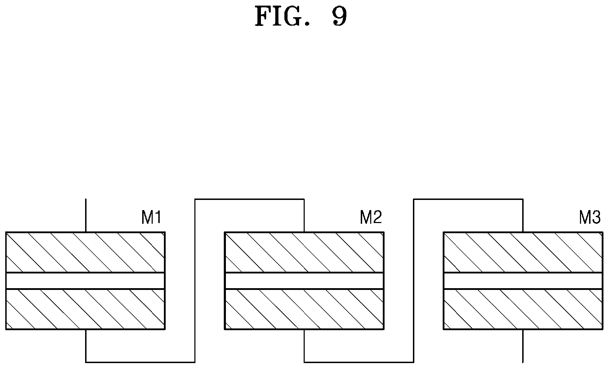

FIG. 9 shows three magnetic memory layers M1, M2, and M3 that are electrically connected in series to each other. Each of the magnetic memory layers M1, M2, and M3 shown in FIG. 9 has the same structure as the magnetic memory layer 151 described with reference to FIG. 1; however, the examples are not limited thereto; and may include, for example the magnetic memory layer 251, 252, and/or 253 described with reference to FIG. 8.

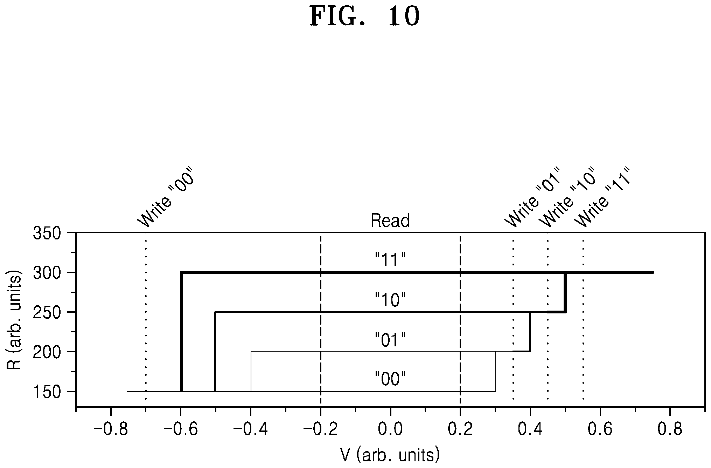

FIG. 10 shows results of simulating the resistance states of the three magnetic memory layers M1, M2, and M2 connected in series to each other as shown in FIG. 9, according to voltages applied to the three magnetic memory layers M1, M2, and M3.

Referring to FIG. 10, when a first voltage V1, a second voltage (V2>V1), and a third voltage V3 (V3>V2) that have a positive (+) polarity for a set operation are applied in an initial state to the three magnetic memory layers M1, M2, and M3 connected in series to each other, the three magnetic memory layers M1, M2, and M3 connected in series to each other may have a "00" state (initial state), a "01" state in which the first voltage V1 is applied, a "10" state in which the second voltage V2 is applied, and a "11" state in which the third voltage V3 is applied. In this case, the resistance of the three magnetic memory layers M1, M2, and M3 connected in series to each other may be M00 (resistance in the "00" state), M01 (resistance in the "01" state), M10 (resistance in the " 10" state), or M11 (resistance in the " 11" state) (where M00<M01<M10<M11). Therefore, the three magnetic memory layers M1, M2, and M3 connected in series to each other may realize four resistance levels or states. In addition, when negative (-) polarity voltages for a reset operation are applied to the three magnetic memory layers M1, M2, and M3 connected in series to each other, the resistance of the three magnetic memory layers M1, M2, and M3 connected in series to each other may be M11, M10, M01, or M00.

As described above, the number of resistance states (levels) of an MRAM including a plurality of magnetic memory layers connected in series to each other may be greater than the number of magnetic memory layers of the MRAM.

Table 2 shows example resistance states that may be implemented according to the height of pulses when pulse voltages having a positive (+) polarity for a set operation are applied as write voltages between the first and second electrodes 110 and 120 of the memory device 200 shown in FIG. 8. Here, each of the write voltages may be the sum of the threshold voltage of the SSM and the threshold voltage of the MRAM.

**[Table 2]**

| **Resistance SET** | **+Vs** | **+(Vs+Vm1)** | **+(Vs+Vm2)** | **+(Vs+Vm3)** |
|---|---|---|---|---|
| R(SSM) | S1 | S1 | S1 | S1 |
| R(MRAM) | M00 | M01 | M10 | M11 |

Referring to Table 2, when voltages having a positive (+) polarity for a set operation, for example, +Vs, +(Vs+Vm1), +(Vs+Vm2), and +(Vs+Vm3) (where Vm1<Vm2<Vm3), are applied to the memory device 200, the resistance R(SSM) of the self-selecting memory layer 240 may be S1 with respect to all of the pulse voltages. In addition, the resistance R(MRAM) of the first, second, and third magnetic memory layers 251, 252, and 253 that are connected in series to each other may be M00, M01, M10, and M11 (M00<M01<M10<Ml 1). Therefore, when pulse voltages having a positive (+) polarity for a set operation, for example, +Vs, +(Vs+Vm1), +(Vs+Vm2), and +(Vs+Vm3), are applied to the memory device 200, the resistance of the memory device 200 may be S1+M00, S1+M01, S1+M10, and S1+M1 1, respectively.

Table 3 shows example resistance states that may be implemented according to the height of pulses when pulse voltages having a positive (-) polarity for a reset operation are applied as write voltages between the first and second electrodes 110 and 120 of the memory device 200 shown in FIG. 8. Here, each of the write voltages may be the sum of the threshold voltage of the SSM and the threshold voltage of the MRAM.

**[Table 3]**

| **Resistance RESET** | **RESET -Vx (SSM)** | **-Vx** | **-(Vx+Vm1)** | **-(Vx+Vm2)** | **(Vx+Vm3)** |
|---|---|---|---|---|---|
| R(SSM) | -V1 | S1 | S1 | S1 | S1 |
| R(MRAM) | | M11 | M10 | M01 | M00 |
| R(SSM) | -V2 | S2 | S2 | S2 | S2 |
| R(MRAM) | | M11 | M10 | M01 | M00 |
| R(SSM) | -V3 | S3 | S3 | S3 | S3 |
| R(MRAM) | | M11 | M10 | M01 | M00 |

Referring to Table 3, when pulse voltages having a negative (-) polarity for a reset operation, for example, -V1 (where -V1 refers to a first reset operation voltage of the SSM), - (V1+Vm1), -(V1+Vm2), and -(V1+Vm3) (where Vm1 <Vm2<Vm3), are applied to the memory device 200, the resistances R(SSM) of the self-selecting memory layer 240 may be S1 with respect to all of the pulse voltages. In addition, the resistance R(MRAM) of the first, second, and third magnetic memory layers 251, 252, and 253 that are connected in series to each other may be M11, M10, M01, and M00 (M00<M01<M10<M11). Therefore, when pulse voltages having a negative (-) polarity for a reset operation, for example, -V1, -(V1+Vm1), -(V1+Vm2), and -(V1+Vm3), are applied to the memory device 200, the resistance of the memory device 200 may be S1+M11, S1+M10, S1+M01, and S1+M00, respectively.

When pulse voltages having a negative (-) polarity for a reset operation, for example, - V2 (where V2>V1, -V2 refers to a second reset operation voltage of the SSM), -(V2+Vm1), - (V2+Vm2), and -(V2+Vm3), are applied to the memory device 200, the resistances R(SSM) of the self-selecting memory layer 240 may be S2 (>S1) with respect to all of the pulse voltages. In addition, the resistance R(MRAM) of the first, second, and third magnetic memory layers 251, 252, and 253 that are connected in series to each other may be M11, M10, M01, and M00. Therefore, when pulse voltages having a negative (-) polarity for a reset operation, for example, - V2, -(V2+Vm1), -(V2+Vm2), and -(V2+Vm3), are applied to the memory device 200, the resistance of the memory device 200 may be S2+M11, S2+M10, S2+M01, and S2+M00, respectively.

When pulse voltages having a negative (-) polarity for a reset operation, for example, - V3 (where V3>V2, -V3 refers to a third reset operation voltage of the SSM), -(V3+Vm1), - (V3+Vm2), and -(V3+Vm3), are applied to the memory device 200, the resistances R(SSM) of the self-selecting memory layer 240 may be S3 (>S2) with respect to all of the pulse voltages. In addition, the resistance R(MRAM) of the first, second, and third magnetic memory layers 251, 252, and 253 that are connected in series to each other may be M11, M10, M01, and M00. Therefore, when pulse voltages having a negative (-) polarity for a reset operation, for example, - V3, -(V3+Vm1), -(V3+Vm2), and -(V3+Vm3), are applied to the memory device 200, the resistance of the memory device 200 may be S3+M11, S3+M10, S3+M01, and S3+M00, respectively.

As described above, the memory device 200 including the self-selecting memory layer 240 and the three magnetic memory layers 251, 252, and 253 may implement multiple levels up to 16 levels. That is, because the self-selecting memory layer 240 implements up to 4 levels and the three magnetic memory layers 251, 252, and 253 connected in series to each other implement multiple levels up to 4 levels, the memory device 200 including the self-selecting memory layer 240 and the three magnetic memory layers 251, 252, and 253 may implement multiple levels up to 16 levels.

The memory device 200 has been described for an example case in which the memory device 200 includes three magnetic memory layers 251, 252, and 253 that are connected in series to each other. However, the number of magnetic memory layers included in the memory device 200 may vary. For example, when the memory device 200 includes the self-selecting memory layer 240 and seven magnetic memory layers, the memory device 200 may implement multiple levels up to 32 levels because the self-selecting memory layer 240 implements four levels, and the seven magnetic memory layers implement eight levels. In addition, the memory device 200 may implement additional levels when voltages having various pulse heights are applied to the memory device 200.

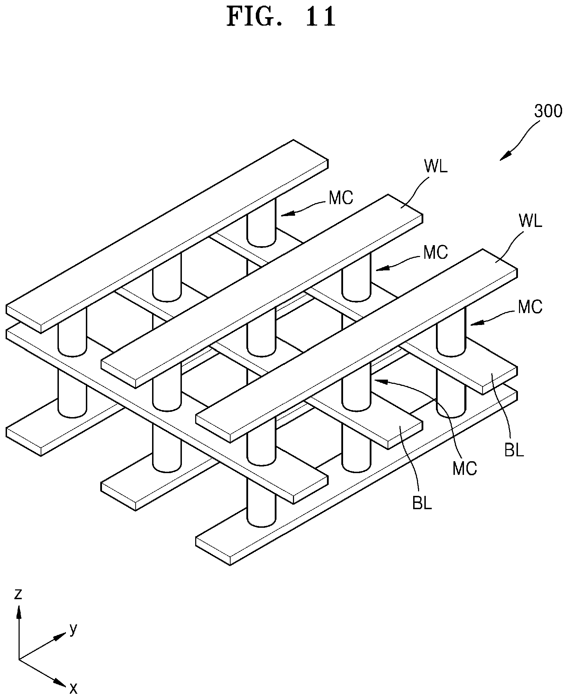

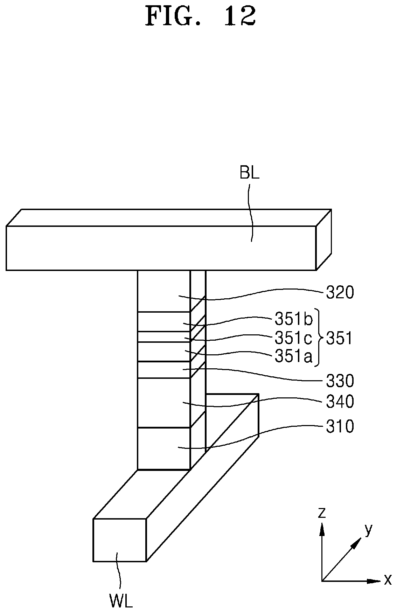

FIG. 11 is a perspective view schematically illustrating a memory device 300 according to another embodiment. FIG. 12 is an enlarged view illustrating one memory cell MC of the memory device 300 shown in FIG. 11.

Referring to FIGS. 11 and 12, the memory device 300 may have a three-dimensional cross-point structure. For example, the memory device 300 may include a plurality of bit lines BL extending in a first direction (that is, an x-axis direction), a plurality of word lines WL extending in a second direction (that is, a y-axis direction) crossing the first direction, and a plurality of memory cells MC provided at points at which the bit lines BL and the word lines WL cross each other.

Each of the memory cells MC may correspond to the memory device 100 described with reference to FIG. 1. For example, a first electrode 310 and a second electrode 320 of each of the memory cells MC may be the same as the first electrode 110 and the second electrode 120 of the memory device 100 described with reference to FIG. 1, and thus, descriptions thereof are omitted here. In at least one embodiment, the first electrode 310 and the second electrode 320 may be formed in one piece with a word line WL and a bit line BL, respectively.

A self-selecting memory layer 340 and a magnetic memory layer 351 that are connected in series to each other are provided between the first and second electrodes 310 and 320. The magnetic memory layer 351 may include a pinned layer 351a, a free layer 351b, and a tunnel barrier layer 351c. The self-selecting memory layer 340 and the magnetic memory layer 351 are the same as the self-selecting memory layer 140 and the magnetic memory layer 151 that are described with reference to FIG. 1, and thus, descriptions thereof are omitted here. A third electrode 330 is provided between the self-selecting memory layer 340 and the magnetic memory layer 351. In another example, each of the plurality of memory cells MC may correspond to the memory device 200 described with reference to FIG. 8.

In the structure described above, each of the memory cells MC may be driven by a potential difference between a word line WL and a bit line BL that are connected to both ends of the memory cell MC and may be implemented as a multi-level memory by adjusting the polarity and magnitude of a voltage applied between the word line WL and the bit line BL.

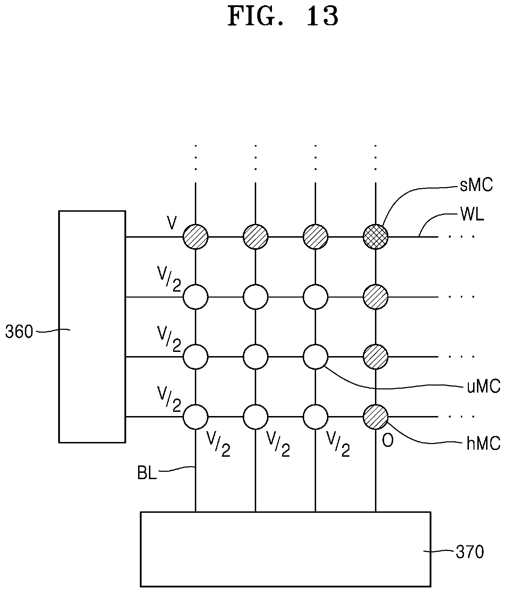

FIG. 13 is a plan view illustrating an operation of selecting a specific memory cell in the memory device 300 shown in FIG. 11.

Referring to FIG. 13, the memory device 300 may further include a row decoder 360 configured to selectively supply a voltage to the word lines WL and a column decoder 370 configured to selectively supply a voltage to the bit lines BL. When a voltage of V is to be applied to a memory cell sMC selected from the memory cells MC, the row decoder 360 may provide a voltage of V to a word line WL connected to the selected memory cell sMC and a voltage of V/2 to the other word lines WL. At this time, the column decoder 370 may provide a voltage of 0 V to a bit line BL connected to the selected memory cell sMC and a voltage of V/2 to the other bit lines BL.

Then, a potential difference between the word line WL and the bit line BL connected to the selected memory cell sMC is V. However, a potential difference between the word lines WL to which a voltage of V/2 is applied and the bit lines BL to which a voltage of V/2 is applied is 0 V. Therefore, no voltage is applied to unselected memory cells uMC arranged between the word lines WL and the bit lines BL that are not connected to the selected memory cell sMC. In addition, a voltage of V/2 may be applied between both ends of each of half-selected memory cells hMC that are connected to the same word line WL as the selected memory cell sMC or the same bit line BL as the selected memory cell sMC. Even when a voltage of V/2 is applied to the half-selected memory cells hMC adjacent to the selected memory cell sMC, the half-selected memory cells hMC do not turn on, and thus, substantially no sneak current may occur.

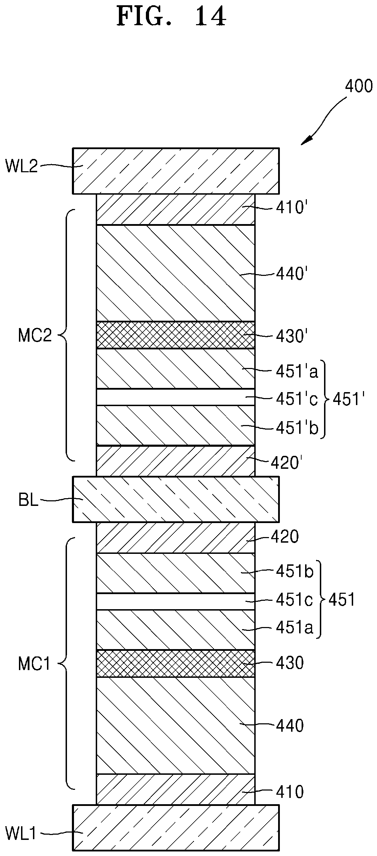

FIG. 14 is a cross-sectional view schematically illustrating a memory device 400 having a multi-layer structure according to another embodiment. The memory device 400 has a multi-layer structure in which bit lines and word lines alternately arranged in a vertical direction. FIG. 14 illustrates a portion of the memory device 400 having a three-dimensional cross-point structure.

Referring to FIG. 14, first and second word lines WL1 and WL2 are arranged side by side in the vertical direction, and a bit line BL is arranged between the first and second word lines WL1 and WL2 in a direction crossing the first and second word lines WL1 and WL2. Here, the bit line BL may be a common bit line.

A first memory cell MC1 is provided between the first word line WL1 and the bit line BL and a second memory cell MC2 is provided between the second word line WL2 and the bit line BL. Here, the first and second memory cells MC1 and MC2 may each correspond to the memory device 100 described with reference to FIG. 1, and thus, repeat descriptions thereof may be omitted here for brevity. Each of the first and second memory cells MC1 and MC2 has a structure in which a first electrode 410 or 410', a self-selecting memory layer 440 or 440', a third electrode 430 or 430', a magnetic memory layer 451 or 451', and a second electrode 420 or 420' are sequentially stacked.

The first and second memory cells MC1 and MC2 are symmetrical with respect to the bit line BL. For example, the first electrode 410 of the first memory cell MC1 and the first electrode 410' of the second memory cell MC2 are symmetrical with respect to the bit line BL, and the second electrode 420 of the first memory cell MC1 and the second electrode 420' of the second memory cell MC2 are symmetrical with respect to the bit line BL. The first electrode 410 of the first memory cell MC1 may be formed in one piece with the first word line WL1, and the first electrode 410' of the second memory cell MC2 may be formed in one piece with the second word line WL2. In addition, the second electrode 420 of the first memory cell MC1 and the second electrode 420' of the second memory cell MC2 may be formed in one piece with the bit line BL.

The self-selecting memory layer 440 of the first memory cell MC1 and the self-selecting memory layer 440' of the second memory cell MC2 are symmetrical around the bit line BL, and the magnetic memory layer 451 of the first memory cell MC1 and the magnetic memory layer 451' of the second memory cell MC2 are symmetrical with respect to the bit line BL. For example, a pinned layer 451a of the first memory cell MC1 and a pinned layer 451'a of the second memory cell MC2 are symmetrical with respect to the bit line BL, and a free layer 451b of the first memory cell MC1 and a free layer 451'b of the second memory cell MC1 are symmetrical around the bit line BL. In addition, a tunnel barrier layer 451c of the first memory cell MC1 and a tunnel barrier layer 451'c of the second memory cell MC2 are symmetrical around the bit line BL. In another example, the first and second memory cells MC1 and MC2 may each correspond to the memory device 200 described with reference to FIG. 8.

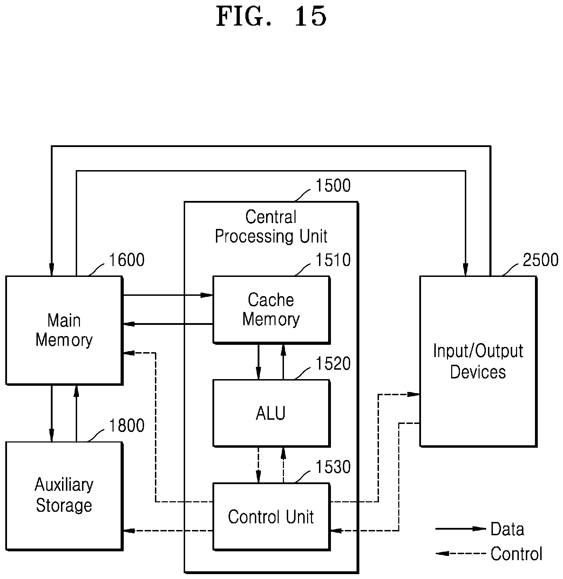

The memory devices 100, 200, 300, and 400 of the embodiments described above may be used to store data in various electronic devices. FIG. 15 is a conceptual diagram schematically illustrating a device architecture that may be applied to electronic devices according to embodiments.

Referring to FIG. 15, a cache memory 1510, an arithmetic logic unit (ALU) 1520, and a control unit 1530 may form a central processing unit (CPU) 1500. The cache memory 1510 may include a static random-access memory (SRAM). A main memory 1600 and an auxiliary storage 1800 may be provided separately from the CPU 1500. The main memory 1600 may include a dynamic random-access memory (DRAM) device, and the auxiliary storage 1800 may include the memory devices 100, 200, 300, and 400. In some cases, the device architectures may be implemented in the form in which unit computing devices and unit memory devices are adjacent to each other on one chip without any distinction between sub-units. In some cases, the device architecture may include input/output devices 2500.

The memory devices 100, 200, 300, and 400 of the embodiments may be implemented as chip-type memory blocks and used as, e.g., a neuromorphic computing platform and/or may be used to construct a neural network.

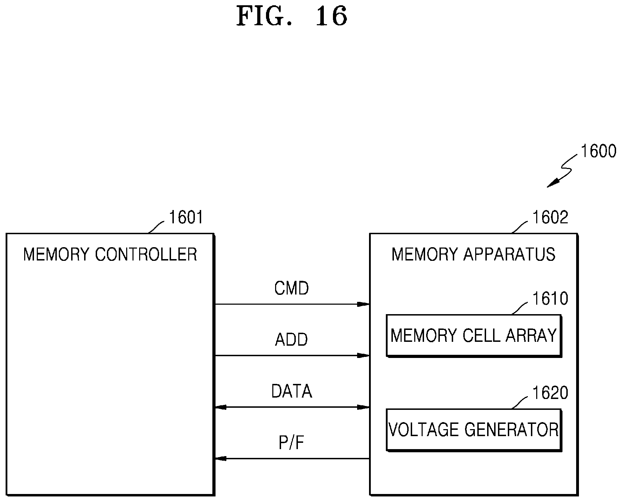

FIG. 16 is a block diagram illustrating a memory system 1600 according to at least one embodiment.

Referring to FIG. 16, the memory system 1600 may include a memory controller 1601 and a memory apparatus 1602. The memory controller 1601 performs a control operation on the memory apparatus 1602. For example, the memory controller 1601 provides, to the memory apparatus 1602, an address ADD and a command CMD for performing programming (or write), read, and/or erase operations on the memory apparatus 1602. In addition, data for a programing operation and read data may be transmitted between the memory controller 1601 and the memory apparatus 1602.

The memory apparatus 1602 may include a memory cell array 1610 and a voltage generator 1620. The memory cell array 1610 may include a plurality of memory cells and the memory devices 100, 200, 300, and 400 of the embodiments described above.

The memory controller 1601 may include processing circuitry such as hardware including a logic circuit; a hardware/software combination such as processor execution software; or a combination thereof. As noted above, examples of the processing circuitry may include a central processing unit (CPU), an arithmetic logic unit (ALU), a digital signal processor, a microcomputer, a field-programmable gate array (FPGA), a system-on-chip (SoC), a programmable logic unit, a microprocessor, and an application-specific integrated circuit (ASIC), but are not limited thereto. The memory controller 1601 may operate in response to a request from a host (not shown), and may be configured to change into a special purpose controller by accessing to the memory apparatus 1602 and controlling a control operation (for example, a write/read operation) discussed above. The memory controller 1601 may generate an address ADD and a command CMD for performing a programming/read/erase operation on the memory cell array 1610. In addition, in response to a command from the memory controller 1601, the voltage generator 1620 (for example, a power circuit) may generate a voltage control signal for controlling a voltage level of a word line to program data in the memory cell array 1610 or read data from the memory cell array 1610.

In addition, the memory controller 1601 may perform a determination operation on data read from the memory apparatus 1602. For example, the number of on-cells and/or the number of off-cells may be determined based on data read from a memory cell. The memory apparatus 1602 may provide a pass/fail signal P/F to the memory controller 1601 according to results of data reading. The memory controller 1601 may control write and read operations of the memory cell array 1610 with reference to the pass/fail signal P/F.

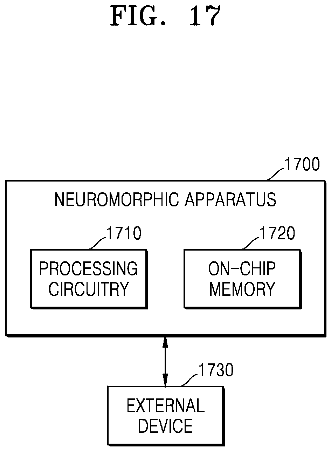

FIG. 17 is a block diagram illustrating a neuromorphic apparatus 1700 and an external device 1730 connected thereto, according to at least one embodiment.

Referring to FIG. 17, the neuromorphic apparatus 1700 may include processing circuitry 1710 and/or a memory 1720. The neuromorphic apparatus 1700 may include the memory devices 100, 200, 300, and 400 of the embodiments described above. For example, the at least one of the processing circuitry 1710 and/or the on-chip memory 1720 may include a plurality of memory cells and the memory devices 100, 200, 300, and 400 of the embodiments described above.

In some examples embodiments, the processing circuitry 1710 may be configured to control a function for driving the neuromorphic apparatus 1700. For example, the processing circuitry 1710 may be configured to control the neuromorphic apparatus 1700 by executing a program stored in the memory 1720. In some examples embodiments, the processing circuitry 1710 may include hardware such as a logic circuit, a hardware/software combination such as a processor configured to execute software, or a combination thereof. For example, the processor may include a CPU, a graphics processing unit (GPU), an application processor (AP) included in the neuromorphic apparatus 1700, an ALU, a digital signal processor, a microcomputer, a FPGA, a SoC, a programmable logic unit, a microprocessor, and an ASIC, but is not limited thereto. In some embodiments, the processing circuitry 1710 may read/write various data with respect to an external device 1730, and/or may be configured to execute the neuromorphic apparatus 1700 using the read/written data. In some embodiments, the external device 1730 may include an external memory and/or a sensor array having an image sensor (for example, a complementary metal-oxide-semiconductor (CMOS) image sensor circuit).

In some embodiments, the neuromorphic apparatus 1700 shown in FIG. 17 may be applied to a machine learning system. The machine learning system may use various artificial neural network organizing and processing models such as a convolutional neural network (CNN), a deconvolutional neural network, a recurrent neural network (RNN) including a long short-term memory (LSTM) unit and/or a gated recurrent unit (GRU), a stacked neural network (SNN), a state-space dynamic neural network (SSDNN), a deep belief network (DBN), a generative adversarial network, and/or a restricted Boltzmann machine (RBM).

Alternatively and/or additionally, the machine learning system may include other forms of machine learning models, for example, linear and/or logistic regression, statistical clustering, Bayesian classification, decision tree, dimensionality reduction such as principal component analysis, an expert system, and/or a combination thereof including ensembles such as random forests. These machine learning models may be used to provide various services and/or applications. For example, an image classification service, a user authentication service based on biometrics or biometric data, an advanced driver assistance system (ADAS) service, a voice assistant service, or an automatic speech recognition (ASR) service may be executed by an electronic device.

As described above, according to the one or more of the above embodiments, a memory device may have a structure in which an SSM and a MRAM are connected in series to each other. The SSM may include a self-selecting memory layer, and the MRAM may include at least one magnetic memory layer. When the MRAM includes a plurality of magnetic memory layers connected in series to each other, multi-level resistance states may be implemented by adjusting the polarity and magnitude of a voltage applied to the memory device. While the memory devices 100, 200, 300, and 400 have been described with reference to the accompanying drawing in which embodiments are shown, the embodiments are merely examples, and it will be understood by those of ordinary skill in the art that various modifications may be made in the embodiments.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A memory cell comprising:
a first electrode;
a second electrode spaced apart from the first electrode;
a self-selecting memory layer between the first and second electrodes, the self-selecting memory layer comprising a chalcogenide-based material, having ovonic threshold switching characteristics, and having a threshold voltage variable based on a polarity and a magnitude of a voltage applied to the self-selecting memory layer; and
a memory layer between the second electrode and the self-selecting memory layer, the memory layer having variable resistance characteristics based on a voltage applied to the memory layer.

2. The memory cell of claim 1, wherein the memory layer comprises at least one magnetic memory layer having variable resistance characteristics, variable with a magnetic field based on the voltage applied thereto.

3. The memory cell of claim 2, wherein the self-selecting memory layer and the at least one magnetic memory layer are electrically connected in series to each other.

4. The memory cell of claim 2, wherein the at least one magnetic memory layer is included in a plurality of magnetic memory layers connected in series to each other.

5. The memory cell of any preceding claim, wherein the memory device is configured such that multi-level resistance states are implemented by varying a polarity and a magnitude of a voltage applied between the first and second electrodes.

6. The memory cell of any preceding claim, wherein the self-selecting memory layer comprises a chalcogen element comprising
at least one of Se, Te, and S, and
at least one of Ge, As, and Sb.

7. The memory cell of any preceding claim, wherein the memory layer comprises a pinned layer,
a free layer spaced apart from the pinned layer, and
a tunnel barrier layer between the pinned layer and the free layer, and optionally wherein:
the pinned layer and the free layer each comprises a ferromagnetic metal material having magnetism; and
the tunnel barrier layer comprises a crystalline metal oxide.

8. The memory cell of any preceding claim, further comprising:
a third electrode between the self-selecting memory layer and the memory layer.

9. A memory device comprising:
a plurality of bit lines;
a plurality of word lines crossing the plurality of bit lines; and
a plurality of memory cells according to any preceding claim at positions at which the plurality of bit lines and the plurality of word lines cross each other,
wherein for each of the plurality of memory cells:
the first electrode is electrically connected to one of a corresponding bit line, of the plurality of bit lines, or a corresponding word line, of the plurality of word lines; and
the second electrode is electrically connected to a remainer of the corresponding bit line or corresponding word line.

10. A method of implementing multiple levels using a memory device comprising a self-selecting memory layer between first and second electrodes, and at least one magnetic memory layer between the second electrode and the self-selecting memory layer, wherein the self-selecting memory layer comprises a chalcogenide-based material, having ovonic threshold switching characteristics, and having a threshold voltage variable based on a polarity and a magnitude of a voltage applied thereto, and the at least one magnetic memory layer has resistance characteristics variable with a magnetic field according to a voltage applied thereto, the method comprising:
implementing multi-level resistance states by varying a polarity and a magnitude of a voltage applied between the first and second electrodes.

11. The method of claim 10, wherein the self-selecting memory layer and the at least one magnetic memory layer are electrically connected in series to each other.

12. The method of claim 11, wherein the at least one magnetic memory layer is included in a plurality of magnetic memory layers connected in series to each other.

13. The method of claim 12, wherein a number of levels in the multi-level resistance states is based on a sum of a first resistance of the self-selecting memory layer and a second resistance of the plurality of magnetic memory layers, and optionally wherein a number of levels of the second resistance is greater than a number of the plurality of magnetic memory layers.

14. The method of claim 13, wherein the implementing multi-level resistance includes, in response to the applied voltage having a first polarity,
maintaining the first resistance as constant, and
varying the second resistance based on variances in a magnitude of the voltage having the first polarity.

15. The method of claim 13, wherein the implementing multi-level resistance includes, in response to the applied voltage having a second polarity,
varying the first resistance and the second resistance based on variances in a magnitude of the voltage having the second polarity.
